Europäisches Patentamt

European Patent Office

Office européen des brevets

(19)

(11) Veröffentlichungsnummer: **0 328 161 B1**

(12)

# EUROPÄISCHE PATENTSCHRIFT

(45) Veröffentlichungstag der Patentschrift: **16.12.92**

(51) Int. Cl.5: **C25D 1/10**, B01D 59/18

(21) Anmeldenummer: **89105375.3**

(22) Anmeldetag: **18.03.86**

(60) Veröffentlichungsnummer der früheren
Anmeldung nach Art. 76 EPÜ: **0 224 630**

(54) Verfahren zum Herstellen einer Vielzahl plattenförmiger Mikrostrukturkörper aus Metall.

(30) Priorität: **22.10.85 DE 3537483**

(43) Veröffentlichungstag der Anmeldung:
**16.08.89 Patentblatt 89/33**

(45) Bekanntmachung des Hinweises auf die
Patenterteilung:
**16.12.92 Patentblatt 92/51**

(84) Benannte Vertragsstaaten:
**AT CH DE FR GB IT LI NL SE**

(56) Entgegenhaltungen:
FR-A- 2 301 355
US-A- 3 649 474

(73) Patentinhaber: **KERNFORSCHUNGSZENTRUM
KARLSRUHE GMBH
Weberstrasse 5 Postfach 3640
W-7500 Karlsruhe 1(DE)**

(72) Erfinder: **Ehrfeld, Wolfgang, Dr.
Reutstrasse 27
W-7500 Karlsruhe 41(DE)**
Erfinder: **Hagmann, Peter, Dr.
Nagoldstrasse 9c
W-7514 Leopoldshafen(DE)**
Erfinder: **Maner, Asim, Dr.
Zwölfmorgen 8
W-7515 Linkenheim(DE)**
Erfinder: **Münchmeyer, Dietrich, Dr.
Hagäckerstrasse 5
W-7513 Stutensee 3(DE)**
Erfinder: **Becker, Erwin, Prof. Dr.
Strählerweg 18
W-7500 Karlsruhe 41(DE)**

# Beschreibung

Die Erfindung betrifft ein Verfahren zum Herstellen einer Vielzahl plattenförmiger Mikrostrukturkörper aus Metall nach dem Oberbegriff von Patentanspruch 1.

Ein Verfahren dieser Art ist aus der US-PS 3,649,474 bekannt. Dabei wird zunächst eine elektrisch leitende, als Galvanikelektrode dienende Schicht wieder lösbar auf die Strukturen eines Formwerkzeugs aufgebracht. Nach dem Abformen der so beschichteten Strukturen des Formwerkzeugs mit einer Abformmasse werden die Negativformen der Strukturen galvanisch mit einem Metall ausgefüllt und sodann die Abformmasse entfernt. Im Zuge des Abformens wird die elektrisch leitende Schicht auf die Abformmasse übertragen, so daß die Negativformen in der Abformmasse vollständig mit der elektrisch leitenden Schicht ausgekleidet sind. Hierbei besteht jedoch die Gefahr, daß sich in engen und tiefen Spalten der Negativformen während des Galvanisierens metallische Brücken zwischen den Spaltwänden ausbilden, die ein vollständiges Auffüllen der Spalten mit Metall bis zum Spaltboden verhindern.

Der Erfindung liegt die Aufgabe zugrunde, ein Verfahren der gattungsgemäßen Art so zu gestalten, daß damit eine störungsfreie galvanische Auffüllung der Negativformen selbst bei sehr hohen Aspektverhältnissen und kleinsten charakteristischen, lateralen Abmessungen der Mikrostrukturen ermöglicht wird.

Für die Lösung dieser Aufgabe werden die im Kennzeichen von Patentanspruch 1 enthaltenen Maßnahmen vorgeschlagen. Patentanspruch 2 beinhaltet eine vorteilhafte Ausgestaltung dieser Maßnahme.

Mit der Erfindung wird erreicht, daß auch sehr enge und tiefe Spalten in den Negativformen der Mikrostrukturen vollständig mit Metall aufgefüllt werden, da zunächst nur die Formböden in der Abformmasse elektrisch leitend sind, so daß die galvanische Abscheidung des Metalls an diesen Formböden beginnt und sich von hier aus, die Negativformen in der Abformmasse fortschreitend ausfüllend, fortsetzt.

Das erfindungsgemäße Verfahren wird im folgenden anhand der Figuren 1 bis 5 näher erläutert:

Figur 1 zeigt als Beispiel einen plattenförmigen Mikrostrukturkörper, für dessen Massenherstellung das erfindungsgemäße Verfahren vorteilhaft angewendet werden kann, in Form einer Wabenstruktur 1 aus Metall im Grundriß. Der Durchmesser der Hohlräume 2 der Waben beträgt bei diesem Ausführungsbeispiel 20μm, die Wandstärke der Zwischenstege 3 2μm und die Strukturhöhe 350 μm.

Die Figuren 2 bis 5 verdeutlichen die Durchführung des erfindungsgemäßen Verfahrens anhand von Querschnitten.

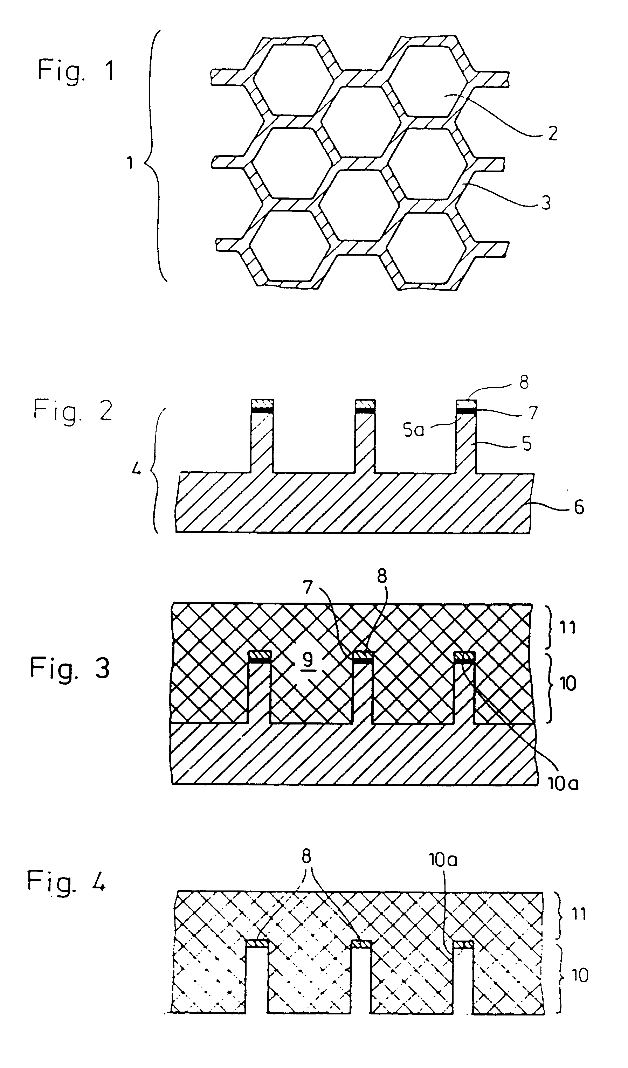

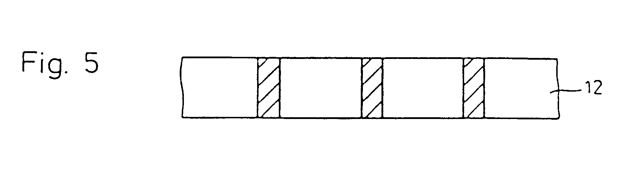

Figur 2 zeigt ein Werkzeug 4 mit Mikrostrukturen 5, die der Wabenstruktur 1 des Mikrostrukturkörpers gemäß Figur 1 entsprechen, und einer fest mit ihnen verbundenen Grundplatte 6. Auf die Stirnflächen der Mikrostrukturen 5 des Werkzeugs 4 wird eine Trennmittelschicht 7 aufgetragen. Dazu wird eine stabile, ebene Metallplatte, die dauerhaft mit einer dünnen, elastischen Auflage beschichtet ist, mit Hilfe des von der Mikroelektronik bekannten Spin-Coatings mit einem handelsüblichen Trennmittel auf Silikonbasis beschichtet. Von diesem Zwischensubstrat (nicht dargestellt) wird Trennmittel durch mechanischen Kontakt auf die Stirnflächen 5a des Werkzeugs 5 übertragen. Anschließend wird ein elektrisch leitendes Material 8, bestehend aus niedermolekularem Polymethylmethacrylat (PMMA), gemischt mit 20 bis 50 Gew.- % Ruß mit einer Teilchengröße von weniger als 0,1 μm (Herstellerbezeichnung "CORAX L" von Fa. Degussa) und Chlorbenzol als Lösungsmittel zur Einstellung der Viskosität, in der gleichen Weise übertragen. Nach der Trocknung des elektrisch leitenden Materials 8 wird das Werkzeug 4 mit einer elektrisch isolierenden Abformmasse 9 ausgefüllt und überschichtet (Figur 3). Als Abformmasse 9 wird ein Gießharz (Herstellerbezeichnung "PLEXIT 60" der Fa. Röhm) dem als Härter 1 % eines phlegmatisierten fünfzigprozentigen Benzoylperoxids beigegeben wurde, verwendet. Zur leichteren Entformung wird dem Gießharz außerdem ein internes Trennmittel in einer Menge von 4 Vol.- % beigegeben. Nach der Warmhärtung der Abformmasse 9, bei der das elektrisch leitende Material 8 mit der aushärtenden Abformmasse 9 eine feste Verbindung eingeht, erfolgt das Entformen der Negativformen 10 unter Verwendung der über die Mikrostrukturen hinausragenden Schicht 11 als Handhabe. Dabei haftet das elektrisch leitende Material 8 auf den Formböden 10a der Negativformen 10, während es sich aufgrund der Trennmittelschicht 7 vollständig vom Werkzeug 7 löst (Figur 4). Durch galvanisches Auffüllen der Negativformen 10 unter Verwendung des elektrisch leitenden Materials 8 als Elektrode und Entfernen der Negativform 10, 11 erhält man einen plattenförmigen Mikrostrukturkörper aus Metall 12 (Figur 5), dessen Grundriß der Wabenstruktur 1 von Figur 1 entspricht.

## Patentansprüche

1. Verfahren zum Herstellen einer Vielzahl plattenförmiger Mikrostrukturkörper (1) aus Metall (12), bei dem durch wiederholtes Abformen eines Mikrostrukturen (5) aufweisenden Werkzeugs (4) mit einer elektrisch isolierenden Abformmasse (9) Negativformen (10, 11) der Mikrostrukturen (5) erzeugt werden, die galvanisch mit dem Metall (12) aufgefüllt werden, wonach die Negativformen (10, 11) entfernt werden, und bei dem elektrisch leitendes Material (8) wieder lösbar auf die Mikrostrukturen (5) des Werkzeugs (4) aufgebracht und im Zuge des Abformens auf die Abformmasse (9) übertragen wird, dadurch gekennzeichnet, daß das elektrisch leitende Material (8) auf die Stirnflächen (5a) wabenförmiger Mikrostrukturen (5) des Werkzeugs (4) aufgebracht wird, von wo es im Zuge des Abformens auf die diesen Stirnflächen (5a) gegenüberliegenden Formböden (10a) der Abformmasse (9) übertragen wird.

2. Verfahren nach Anspruch 1, dadurch gekennzeichnet, daß das elektrisch leitende Material (8) zunächst als gleichförmige, dünne Schicht auf ein Zwischensubstrat aufgebracht und von dort durch mechanischen Kontakt auf die Stirnflächen (5a) der Mikrostrukturen (5) des Werkzeugs (4) übertragen wird.

## Claims

1. Method of producing a plurality of plate-shaped microstructural bodies (1) from metal (12), wherein, by repeatedly shaping a tool (4), having microstructures (5), with an electrically insulating shaping substance (9), negative forms (10, 11) of the microstructures (5) are produced, which negative forms are galvanically filled with the metal (12), whereupon the negative forms (10, 11) are removed, and wherein electrically conductive material (8) is applied to the microstructures (5) of the tool (4) so as to be detachable therefrom again and is transferred to the shaping substance (9) during the shaping process, characterised in that the electrically conductive material (8) is applied to the end faces (5a) of honeycomb-shaped microstructures (5) of the tool (4), whence it is transferred to the form bases (10a) of the shaping substance (9), which are situated opposite these end faces (5a), during the shaping process.

2. Method according to claim 1, characterised in that the electrically conductive material (8) is initially applied to an intermediate substrate as a uniform, thin layer and thence transferred, by mechanical contact, to the end faces (5a) of the microstructures (5) of the tool (4).

## Revendications

1. Procédé de production d'un corps de microstructure (1) en métal (12), dans lequel on réalise des formes négatives (10, 11) des microstructures (5) par moulage répété d'un outil (4) comportant des microstructures (5) avec une substance de moulage (9) isolante électrique, formes négatives qui sont remplies par galvanoplastie avec le métal (12), à la suite de quoi les formes négatives (10, 11) sont enlevées, et procédé dans lequel on applique sur les microstructures (5) de l'outil (4) de la matière (8) conductrice électrique pouvant être ensuite retirée et transférée au cours du moulage sur la substance de moulage (9), caractérisé en ce que

- la matière (8) conductrice électrique est appliquée sur les faces frontales (5a) des microstructures (5) en forme de nids d'abeilles de l'outil (4), d'où elle est transférée au cours du moulage sur les fonds des formes (10a) de la substance de moulage (9), opposées à ces faces frontales (5a).

2. Procédé selon la revendication 1, caractérisée en ce que

- la matière (8) conductrice électrique est d'abord appliquée en couche homogène et mince sur un substrat intermédiaire et de la est transférée par contact mécanique sur les faces frontales (5a) des microstructures (5) de l'outil (4).

Fig. 1

1 {

2

3

Fig. 2

4 {

8

7

5a

5

6

Fig. 3

7

8

9

11

10

10a

Fig. 4

8

10a

11

10

Fig. 5

—12